(19) Europäisches Patentamt
European Patent Office
Office européen des brevets

(11) **EP 3 278 448 B1**

(12) **EUROPÄISCHE PATENTSCHRIFT**

(45) Veröffentlichungstag und Bekanntmachung des Hinweises auf die Patenterteilung:
**09.06.2021 Patentblatt 2021/23**

(51) Int Cl.:
*H02P 23/14* (2006.01)  *G01R 19/02* (2006.01)

(21) Anmeldenummer: **16703967.6**

(86) Internationale Anmeldenummer:
**PCT/EP2016/052756**

(22) Anmeldetag: **10.02.2016**

(87) Internationale Veröffentlichungsnummer:
**WO 2016/155925 (06.10.2016 Gazette 2016/40)**

(54) **VERFAHREN UND VORRICHTUNG ZUM SCHÄTZEN EINES EFFEKTIVSTROMS EINES ZWISCHENKREISKONDENSATORS FÜR EINEN WECHSELRICHTER**

METHOD AND APPARATUS FOR ESTIMATING AN RMS CURRENT OF AN INTERMEDIATE CIRCUIT CAPACITOR FOR AN INVERTER

PROCÉDÉ ET DISPOSITIF D'ESTIMATION D'UN COURANT EFFICACE D'UN CONDENSATEUR DE CIRCUIT INTERMÉDIAIRE POUR UN ONDULEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **01.04.2015 DE 102015205961**

(43) Veröffentlichungstag der Anmeldung:
**07.02.2018 Patentblatt 2018/06**

(73) Patentinhaber: **Robert Bosch GmbH**
**70442 Stuttgart (DE)**

(72) Erfinder:
• **ZIMMERMANN, Daniel**
**06429 Nienburg (DE)**

• **HIRSCH, Michele**
**73730 Esslingen (DE)**
• **DJONGA, Christian**
**74081 Heilbronn (DE)**

(56) Entgegenhaltungen:
**EP-A2- 1 988 402    DE-A1-102012 215 811**

• **KOLAR J W ET AL: "Analytical calculation of the RMS current stress on the DC-link capacitor of voltage-PWM converter systems", IEE PROCEEDINGS: ELECTRIC POWER APPLICATIONS, INSTITUTION OF ELECTRICAL ENGINEERS, GB, Bd. 153, Nr. 4, 1. Juli 2006 (2006-07-01), Seiten 535-543, XP006026699, ISSN: 1350-2352**

**Beschreibung**

Die vorliegende Erfindung betrifft ein Verfahren und eine Vorrichtung zum Schätzen eines Effektivstroms eines Zwischenkreiskondensators für ein Gesamtsystem einer Batterie, eines Wechselrichters und einer elektrischen Maschine.

Stand der Technik

Bei Hybrid- und Elektrofahrzeugen werden zur Ansteuerung der elektrischen Maschinen Wechselrichter bzw. Pulswechselrichter eingesetzt. Nicht nur zu Überwachungszwecken ist die Kenntnis eines sogenannten Effektivstroms eines Zwischenkreiskondensators wünschenswert.

Die bekannten Konzepte zur Berechnung des Effektivstroms des Zwischenkreiskondensators nehmen analytische Berechnungen vor, die aber nur für spezielle Ansteuerverfahren bzw. Pulsmuster des Wechselrichters gelten. Die bekannten Konzepte bieten daher keine Möglichkeit zur Berechnung des Effektivstroms des Zwischenkreiskondensators für beliebige Ansteuerverfahren und Betriebspunkte des Wechselrichters und der elektrischen Maschine.

Die wissenschaftliche Veröffentlichung "Analytical calculation of the RMS current stress on the DC-link capacitor of voltage-PWM converter systems", IEE PROCEEDINGS: ELECTRIC POWER APPLICATIONS, INSTITUTION OF ELECTRICAL ENIGNEERS, GB, Bd. 153, Nr. 4, 1. Juli 2006 (2006-07-01), Seiten 535-543, XP006026699, ISSN: 1350-2352 beschreibt ein Verfahren zum Berechnen eines Effektivstroms eines Zwischenkreiskondensators für ein Gesamtsystem bestehend aus einem Gleichrichter, einem Wechselrichter und einer N-phasigen elektrischen Maschine. Der Effektivstrom des Zwischenkreiskondensators wird gemäß einer Berechnungsvorschrift berechnet, welche vorgegebene Schaltzeiten der elektrischen Maschine, gemessene Phasenströme und einen vorgegebenen Gleichstrom als Eingangsgrößen berücksichtigt. Die Offenlegungsschrift EP 1 988 402 A1 beschreibt ein Verfahren zur Bestimmung der elektrischen Arbeit in Systemen, in denen die Spannung geschaltet wird. Dabei ist vorgesehen, dass zu vorgegebenen Zeitpunkten Stromwerte gemessen werden und die Stromwerte zwischen den Messungen interpoliert werden. Das Dokument DE 10 2012 215 811 A1 beschreibt ein Verfahren zum Betreiben eines Wechselrichters, wobei der Wechselrichter eine Mehrzahl von steuerbaren Schaltern aufweist, die wechselnd geschaltet werden, um einen mehrphasigen elektrischen Strom an eine entsprechende Mehrzahl von Phasenleitungen des Wechselrichters bereitzustellen.

Offenbarung der Erfindung

Daher besteht die Aufgabe der vorliegenden Erfindung in der Bereitstellung eines Verfahrens und einer Vorrichtung zum Schätzen eines Effektivstroms eines Zwischenkreiskondensators für ein Gesamtsystem einer Batterie, eines Wechselrichters und einer N-phasigen elektrischen Maschine, wobei das Verfahren und die Vorrichtung für beliebige Ansteuerverfahren und Betriebsarten des Wechselrichters und der elektrischen Maschine eine exakte Schätzung des Effektivstroms des Zwischenkreiskondensators ermöglichen sollen.

Die Aufgabe der vorliegenden Erfindung wird durch ein Verfahren gemäß Anspruch 1 sowie durch eine Vorrichtung gemäß Anspruch 8 gelöst. Vorteilhafte Ausführungsformen ergeben sich aus den abhängigen Ansprüchen.

Es wird ein Verfahren bereitgestellt zum Schätzen eines Effektivstroms eines Zwischenkreiskondensators für ein Gesamtsystem einer Batterie, eines Wechselrichters und einer N-phasigen elektrischen Maschine, die bevorzugt als Synchronmaschine ausgebildet ist, wobei in dem Gesamtsystem der Wechselrichter eine von der Batterie empfangene Gleichstromleistung zur Bestromung der elektrischen Maschine mit N Phasenströmen umrichtet, und wobei der zu schätzende Effektivstrom des Zwischenkreiskondensators gemäß einer Berechnungsvorschrift berechnet wird, der vorgegebene Schaltzeiten der N Phasen der elektrischen Maschine, gemessene Phasenströme von N-1 Phasen oder N Phasen der elektrischen Maschine und ein vorgegebener Batteriegleichstrom als Eingangsgrößen zugeführt werden. Unter dem Begriff der Batterie wird jeder Energiespeicher verstanden, der einen Gleichstrom als Batteriestrom unmittelbar oder mittelbar bereitstellen kann.

Das Verfahren ermöglicht eine exakte Schätzung bzw. Berechnung des Effektivstroms des Zwischenkreiskondensators unabhängig vom Ansteuerverfahren bzw. Pulsansteuerverfahren und einem Betriebspunkt des Wechselrichters. Somit stellt das Verfahren erhebliche Vorteile gegenüber dem oben erwähnten bekannten Konzept bereit.

Die Erfindung ist grundsätzlich zur Schätzung des Effektivstroms des Zwischenkreiskondensators für beliebige Wechselrichter geeignet. Sie ist besonders geeignet zur Schätzung des Effektivstroms des Zwischenkreiskondensators für Pulswechselrichter. Die Begriffe Wechselrichter und Pulswechselrichter werden deshalb in dieser Beschreibung und den Ansprüchen ohne weitere Unterscheidung synonym verwendet. Die Begriffe Effektivstrom und rms-Strom bzw. RMS-Strom bezeichnen denselben Strom.

Gemäß einer Ausführungsform des Verfahrens berechnet die Berechnungsvorschrift, als jeweilige quadratische Integrale, Quadrate von in Schaltkomponenten des Wechselrichters fließenden elektrischen Ladungen auf Grundlage der zugeführten Eingangsgrößen. Dies ermöglicht eine effiziente und exakte Berechnung des zu schätzenden Effektivstroms für beliebige Pulsmuster zur Ansteuerung des Wechselrichters.

Gemäß einer weiteren Ausführungsform des Verfahrens für einen symmetrischen Wechselrichter bzw. Pulswechselrichter wird auf Grundlage der gemessenen Phasenströme der N-1 Phasen ein Phasenstrom einer von den N-1 Phasen unterschiedlichen, N-ten Phase berechnet und der Berechnungsvorschrift als Phasenstrom der N-ten Phase zugeführt. Somit werden nicht N sondern nur N-1 Phasenstromsensoren benötigt, so dass ein einzelner Phasenstromsensor durch Nutzung des Verfahrens eingespart werden kann und an der elektrischen Maschine nicht bereitgestellt werden muss. Die Möglichkeit zur Nutzung von nur N-1 Phasenstromsensoren bei N-Phasen nutzt die Symmetrie der elektrischen Maschine und des diese ansteuernden Wechselrichters aus.

Gemäß einer weiteren Ausführungsform des Verfahrens berechnet die Berechnungsvorschrift für mindestens eine Phase, bevorzugt alle, der N Phasen, als ein quadratisches Integral, ein Zeitintegral eines Quadrats eines der jeweiligen Phase zugeordneten und als Eingangsgröße zugeführten Phasenstroms auf Grundlage der der Phase zugeordneten und als Eingangsgröße zugeführten Schaltzeiten. Dies ermöglicht eine effiziente und exakte Berechnung des zu schätzenden Effektivstroms für beliebige Pulsmuster zur Ansteuerung des Wechselrichters. Dies ermöglicht eine besonders effiziente und exakte Berechnung des zu schätzenden Effektivstroms für beliebige Pulsmuster zur Ansteuerung des Wechselrichters.

Gemäß einer weiteren Ausführungsform des Verfahrens berechnet die Berechnungsvorschrift für zwei Phasen der N Phasen, als ein gemischtes Integral, ein Zeitintegral eines Produkts der diesen Phasen zugeordneten und als Eingangsgrößen zugeführten Phasenströme auf Grundlage der den Phasen zugeordneten und als Eingangsgrößen zugeführten Schaltzeiten.

Der Begriff des quadratischen Integrals soll einheitlich ein Zeitintegral eines gemessenen oder der Berechnungsvorschrift zugeführten, quadrierten Phasenstroms bezeichnen. Da die Berechnung eines Zeitintegrals eines Stroms, also der Integration des zeitabhängigen Stromwertes über die Zeit bzw. für die vorgegebenen Schaltzeiten (im Sinne einer Einschaltzeit und einer Auschaltzeit des Stroms), eine fließende elektrische Ladung definiert, kann das quadratische Integral als Quadrat der Ladung oder quadriertes Stromintegral aufgefasst werden.

Der Begriff des gemischten Integrals soll einheitlich in dieser Beschreibung ein Zeitintegral eines Produkts zweier gemessener oder der Berechnungsvorschrift zugeführter Phasenströme bezeichnen. Ein gemischtes Integral mit zwei identischen zu multiplizierenden Phasenströmen ergibt ein quadratisches Integral.

Gemäß einer weiteren Fortbildung der obigen Ausführungsform des Verfahrens berechnet die Berechnungsvorschrift für genau zwei Phasen der N=3 Phasen, als ein gemischtes Integral, das Zeitintegral des Produkts der diesen Phasen zugeordneten und als Eingangsgrößen zugeführten Phasenströme auf Grundlage von genau einer Phase der zwei Phasen zugeordneten und als Eingangsgröße zugeführten Schaltzeiten, wobei ferner bevorzugt die genau zwei Phasen eine Phase mit einer zweitkleinsten Leitend-Zeitdauer und eine Phase mit einer größten Leitend-Zeitdauer sind, und wobei ferner bevorzugt die Berechnung nur auf Grundlage der der Phase mit der zweitkleinsten Leitend-Zeitdauer zugeordneten Schaltzeiten durchgeführt wird.

Dies ermöglicht eine überaus effiziente und exakte Berechnung des zu schätzenden Effektivstroms für beliebige Pulsmuster zur Ansteuerung des Wechselrichters.

Die Leitend-Zeitdauer entspricht dem Hoch-Pegel bzw. High-Pegel des jeweiligen Ansteuersignals für eine Phase des Wechselrichters und wird bei Normierung auf die Periodendauer eines PWM-Ansteuermusters auch Tastfaktor, Aussteuergrad oder Duty Cycle (abgekürzt mit dyc) genannt.

Erfindungsgemäß verwendet die Berechnungsvorschrift die vorgegebenen Schaltzeiten zur Festlegung von Intervallgrenzen durch die Berechnungsvorschrift zu berechnender Zeitintegrale, wobei sie bevorzugt die vorgegebenen Schaltzeiten als die Intervallgrenzen verwendet. Dies ermöglicht eine besondere effiziente Berechnung des zu schätzenden Effektivstroms.

Erfindungsgemäß berechnet die Berechnungsvorschrift für eine jeweilige Phase, als ein quadratisches Integral, ein Zeitintegral eines quadrierten zugeführten Phasenstroms und/oder für zwei Phasen, als ein gemischtes Integral, ein Zeitintegral eines Produkts der diesen Phasen zugeordneten und zugeführten Phasenströme mittels Approximation des jeweiligen zugeführten Phasenstroms durch eine quadratische Funktion, insbesondere ein Polynom zweiten Grades. Diese Approximation, die untenstehend sehr detailliert hergeleitet und erläutert wird, ermöglicht eine besonders effiziente und zugleich exakte Berechnung des zu schätzenden Effektivstroms des Zwischenkreiskondensators.

Gemäß einer weiteren Ausführungsform des Verfahrens berechnet die Berechnungsvorschrift die quadratischen Integrale und die gemischten Integrale für beliebige, insbesondere von einem Flat-Top-Pulsmuster unterschiedliche, Pulsmuster zur Ansteuerung des Wechselrichters nur für High-Side-Schaltkomponenten des Wechselrichters. Dies ermöglicht eine besondere effiziente Berechnung des zu schätzenden Effektivstroms für beliebige Pulsmuster zur Ansteuerung des Wechselrichters.

Optional oder gemäß einer weiteren Ausführungsform des Verfahrens berechnet die Berechnungsvorschrift für Flat-Top-Pulsmuster zur Ansteuerung des Wechselrichters die quadratischen Integrale und die gemischten Integrale nur für Low-Side-Schaltkomponenten des Wechselrichters. Für einen Wechselrichter bzw. Pulswechselrichter mit Flat-Top-Ansteuerung ermöglicht dies eine Reduzierung der zu berechnenden Integrale.

Gemäß einer weiteren Ausführungsform des Verfahrens berechnet die Berechnungsvorschrift den zu schätzenden Effektivstrom des Zwischenkreiskondensators als eine Summe der berechneten quadratischen und gemischten Integrale abzüglich des vorgegebenen Batteriegleichstroms, wobei das quadratische Integral der Phase mit der kleinsten Leitend-Zeitdauer negativ in die Summe eingeht. Die Summierung der Integrale ermöglicht eine effiziente Berechnung des Effektivstroms.

Außerdem wird eine Vorrichtung bereitgestellt zum Schätzen eines Effektivstroms bzw. rms-Stroms eines Zwischenkreiskondensators für ein Gesamtsystem einer Batterie, eines Wechselrichters und einer N-phasigen elektrischen Maschine, die bevorzugt als Synchronmaschine ausgebildet ist, wobei in dem Gesamtsystem der Wechselrichter dafür vorgesehen ist, eine von der Batterie empfangene Gleichstromleistung zur Bestromung der elektrischen Maschine mit N Phasenströmen umzurichten, und wobei die Vorrichtung ausgebildet ist zum Berechnen des zu schätzenden Effektivstroms des Zwischenkreiskondensators gemäß einer Berechnungsvorschrift, der vorgegebene Schaltzeiten der N Phasen der elektrischen Maschine, gemessene Phasenströme von N-1 Phasen oder N Phasen der elektrischen Maschine und ein vorgegebener Batteriegleichstrom als Eingangsgrößen zugeführt werden.

Erfindungsgemäß ist die Vorrichtung ferner ausgebildet zum Ausführen mindestens eines Verfahrens nach einem der Ansprüche 1 bis 9.

Außerdem wird als ein Verfahren eine Verwendung einer der zuvor oder nachfolgend dargestellten Ausführungsformen des Verfahrens oder einer der zuvor oder nachfolgend dargestellten Ausführungsformen der Vorrichtung in einer Steuerungsvorrichtung oder einer Regelungsvorrichtung, insbesondere einem Wechselrichter bzw. Pulswechselrichter, für einen elektrischen Antrieb eines Elektro- oder Hybridfahrzeugs mit dem Zweck eines Überwachens oder Vermeidens von Schäden des elektrischen Antriebs oder des Wechselrichters bzw. Pulswechselrichters bereitgestellt.

Verfahrensgemäß offenbarte Merkmale der Erfindung sollen durchweg auch als vorrichtungsgemäß offenbart gelten, und umgekehrt.

Die vorliegende Erfindung und die erläuterten Ausführungsformen sind nicht auf eine dreiphasige elektrische Maschine beschränkt, sondern können für beliebige elektrische Maschinen mit N (N ist eine ganze Zahl und größer gleich 1) Phasen genutzt werden. Zur Einfachheit der folgenden Beschreibung greift die folgende Beschreibung beispielhaft eine elektrische Maschine mit N=3 Phasen, also eine dreiphasige elektrische Maschine auf.

Zum besseren Verständnis der vorliegenden Erfindung werden nun beispielhafte Ausführungsformen erläutert. Die folgende Erläuterung umfasst auch eine ausführliche Herleitung der Berechnungsvorschrift zum Schätzen des Effektivstroms des Zwischenkreiskondensators. Diese Herleitung wird mit Hilfe von Gleichungen erfolgen, die in einem inhaltlichen Hauptabschnitt einheitlich als (x) usw. und in einem inhaltlichen Nebenabschnitt einheitlich als (Vx) usw. nummeriert sind. In den Figuren sind dieselben oder ähnliche Komponenten oder Einheiten mit denselben Bezugszeichen versehen.

Im Folgenden soll die Erfindung anhand der Zeichnung näher erläutert werden.

Dazu zeigen

Figur 1          ein Gesamtsystem,

Figuren 2A bis 2D     ein Center-Aligned-PWM-Muster, ein Center-Alignedinvertiert-PWM-Muster, ein Left-Aligned-PWM-Muster und ein Right-Aligned-PWM-Muster über eine Periodendauer,

Figuren 3A und 3B     ein Only-High-PWM-Muster und ein Only-Low-PWM-Muster über eine Periodendauer,

Figuren 4A und B      ein Center-Aligned-Pulsmusters und ein Flat-Top-Pulsmuster und

Figur 5          eine Vorrichtung zum Schätzen des Effektivstroms des Zwischenkreiskondensators.

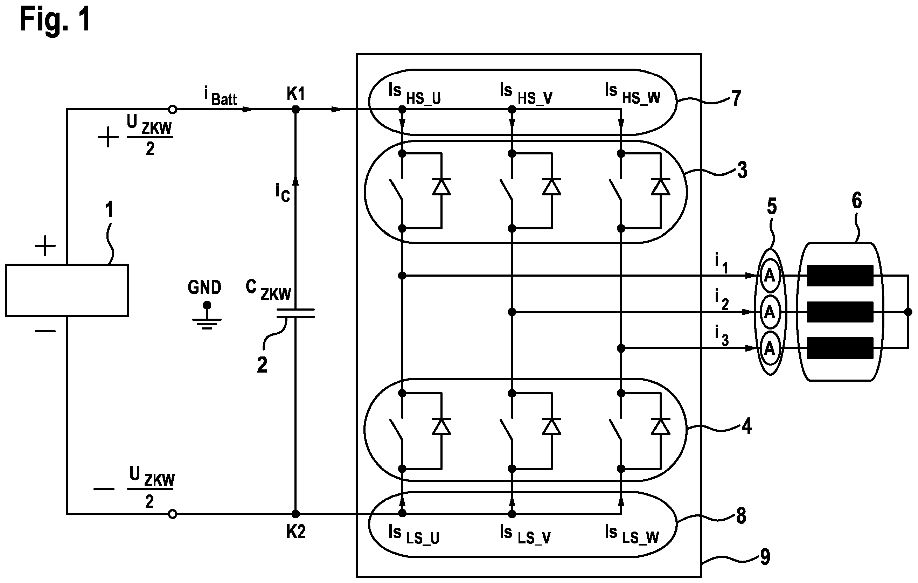

Zunächst soll mit Verweis auf Fig. 1 ein Gesamtsystem dargestellt werden, in dem das erfindungsgemäße Verfahren und die entsprechende Vorrichtung eingesetzt werden können.

In Fig. 1 sind eine Batterie 2, ein Wechselrichter 9 und eine elektrische Maschine 6 dargestellt. Die Batterie 1 stellt eine Gleichspannung und einen Strom $i_{Batt}$ für eine Eingangsseite des Wechselrichters 9 bereit. Zwischen einem leitend mit dem positiven Anschluss der Batterie 1 verbundenen Kontaktpunkt K1 und einem leitend mit dem negativen Anschluss der Batterie 1 verbundenen Kontaktpunkt K2 ist ein Zwischenkreiskondensator 2 mit einem zugehörigen Strom $i_C$ dargestellt.

Der Wechselrichter 9 ist als Pulswechselrichter zur Bereitstellung von drei Phasen U, V und W mit einer Vollbrücke ausgebildet. Eine obere Hälfte bzw. die High-Side 3 (abgekürzt in den Figuren und den folgenden Formeln mit "HS") der Vollbrücke umfasst für jede Phase U, V und W eine jeweilige Parallelschaltung eines Leistungsschalters, durch einen IGBT verkörpert, und einer Leistungsdiode. Diese drei Leistungsschalter und drei Leistungsdioden werden auch als High-Side-Schaltkomponenten oder High-Side-Leistungshalbleiter des Wechselrichters bezeichnet. Eine untere Hälfte bzw. die Low-Side 4 (abgekürzt in den Figuren und den folgenden Formeln mit "LS") der Vollbrücke ist entsprechend bzw. symmetrisch zu der High-Side 3 ausgebildet und umfasst somit ebenfalls drei Leistungsschalter und drei Leistungsdioden, die auch als Low-Side-Schaltkomponenten oder Low-Side-Leistungshalbleiter des Wechselrichters bezeichnet werden.

Die Phasenströme im Wechselrichter 9 sind in Fig. 1 und den folgenden Herleitungen mit IS und der jeweiligen Phase U, V oder W und der jeweiligen Eingangsseite in den Wechselrichter, also HS für die High-Side und LS für die Low-Side, gekennzeichnet. Die High-Side-Phasenströme sind in Fig. 1 mit Bezugszeichen 7 zusammengefasst. Die Low-Side-Phasenströme sind in Fig. 1 mit Bezugszeichen 8 zusammengefasst.

Die elektrische Maschine 6 ist eine Dreiphasen-Maschine, deren drei Phasen über den zuvor erläuterten Wechselrichter 9 bestromt werden. Zur Messung der Phasenströme der elektrischen Maschine ist für jede der Phasen U, V und W je ein Phasenstromsensor der drei Phasenstromsensoren 5 bereitgestellt.

Aus Gründen der Einfachheit der Beschreibung und zur Verdeutlichung eines besonderen Vorteils der Erfindung wird im Folgenden von einem symmetrischen Wechselrichter ausgegangen. Wie später erläutert werden wird, reicht es für das Verfahren und die Vorrichtung dann aus, dass nur zwei der drei Phasenströme der elektrischen Maschine mit nur zwei Phasenstromsensoren 5 gemessen werden.

Im Folgenden soll die Berechnung mit der Berechnungsvorschrift des Verfahrens und der entsprechenden Vorrichtung hergeleitet werden.

Dazu wird zunächst die Knotengleichung für Knoten K1 in Fig. 1 aufgestellt. Man erhält als Gleichung (1):

$$(K1) \Rightarrow i_{Batt} = i_C + Is_{HS\_U} + Is_{HS\_V} + Is_{HS\_W}$$

$$\Rightarrow i_{Batt} - i_C = Is_{HS\_U} + Is_{HS\_V} + Is_{HS\_W}$$

$$(1)$$

Zur Berechnung des Effektivstroms $I_{C,rms}$ des Zwischenkreiskondensators $C_{ZWK}$ muss die Gleichung (1) auf beiden Seiten quadriert werden:

$$\left(i_{Batt} - i_C\right)^2 = \left(Is_{HS\_U} + Is_{HS\_V} + Is_{HS\_W}\right)^2$$

$$(2)$$

Die Lösung dieser binomischen Gleichung ergibt:

$$\left(i_{Batt}^2 - 2i_{Batt} \cdot i_C + i_C^2\right) = \left(\begin{array}{l} Is_{HS\_U}^2 + Is_{HS\_V}^2 + Is_{HS\_W}^2 + 2 \cdot Is_{HS\_U} \cdot Is_{HS\_V} \\ + 2 \cdot Is_{HS\_U} \cdot Is_{HS\_W} + 2 \cdot Is_{HS\_V} \cdot Is_{HS\_W} \end{array}\right)$$

$$(3)$$

Nun wird auf beiden Seiten der Gleichung (3) über eine PWM-Periode integriert. Dabei werden die Schaltzeiten normiert. Somit ergibt sich die Gleichung (4):

$$\left(\int_0^1 i_{Batt}^2 dt - 2\int_0^1 i_{Batt} i_C dt + \int_0^1 i_C^2 dt\right) = \left(\begin{array}{l} \int_0^1 Is_{HS\_U}^2 dt + \int_0^1 Is_{HS\_V}^2 dt + \int_0^1 Is_{HS\_W}^2 + 2\int_0^1 Is_{HS\_U} Is_{HS\_V} dt \\ + 2\int_0^1 Is_{HS\_U} Is_{HS\_W} dt + 2\int_0^1 Is_{HS\_V} Is_{HS\_W} dt \end{array}\right)$$

$$(4)$$

Da der DC-Strom am Zwischenkreiskondensator über eine elektrische Periode gesehen gleich Null ist, gilt:

$$-2\int_0^1 i_{Batt} \cdot i_C \cdot dt = 0$$

Setzt man die Integralgrenzen in die Gleichung (4) ein, erhält man die folgende zu lösende Gleichung (5):

$$\int_0^1 i_C^2 dt = \underbrace{\int_{t_{on,U}}^{t_{off,U}} Is_{HS\_U}^2 dt}_{Q_{SqHS\_U}} + \underbrace{\int_{t_{on,V}}^{t_{off,V}} Is_{HS\_V}^2 dt}_{Q_{SqHS\_V}} + \underbrace{\int_{t_{on,W}}^{t_{off,W}} Is_{HS\_W}^2 dt}_{Q_{SqHS\_W}} +$$

$$2\int_{t_{on,U};t_{on,V}}^{t_{off,U};t_{off,V}} Is_{HS\_U} Is_{HS\_V} dt + 2\int_{t_{on,U};t_{on,W}}^{t_{off,U};t_{off,W}} Is_{HS\_U} Is_{HS\_W} dt + 2\int_{t_{on,V};t_{on,W}}^{t_{off,V};t_{off,W}} Is_{HS\_V} Is_{HS\_W} dt - I_B^2$$

$$(5)$$

Nun wird erläutert bzw. hergeleitet, wie die ersten drei Terme der Gleichung (5), $Q_{SqHS\_U}$, $Q_{SqHS\_V}$, $Q_{SqHS\_W}$, also die quadratischen Integrale, ermittelt werden können.

Hierzu wird ein besonders effizientes Approximationsverfahren zur Berechnung von Stromintegralen bzw. der Ladungen in den Schaltkomponenten des Wechselrichters verwendet werden. Dieses Approximationsverfahren umfasst eine Normierung der Schaltzeiten des Wechselrichters, eine Approximation eines jeweiligen Phasenstroms durch eine quadratische Gleichung und eine Auswertung der PWM-Ansteuerungs-Pulsmuster zur Berechnung der in den Komponenten, also den Leistungshalbleitern, des Wechselrichters fließenden elektrischen Ladungen bzw. der entsprechenden Stromintegrale und auch quadratischer Integrale.

Die Normierung der Schaltzeiten, zunächst allgemein als $t_{Ein}$ und $t_{AUS}$ bezeichnet, innerhalb einer Periodendauer eines PWM-Ansteuermusters ist notwendig zur Vereinfachung der zu bestimmenden Stromintegrale sowie zur Einhaltung der Berechnungsgültigkeit für verschiedene Schaltfrequenzen. Die normierten ("Nrm") Schaltzeiten werden wie folgt berechnet:

$$t_{Ein,Nrm} = \frac{t_{Ein}}{T_{PWM}}, \qquad t_{Aus,Nrm} = \frac{t_{Aus}}{T_{PWM}} \qquad\qquad (V5)$$

Dabei ist $T_{PWM}$ die Periodendauer eines PWM-Ansteuermusters.

Nun wird der Stromverlauf einer beliebigen Phase (deshalb ohne Bezeichnung) durch ein Polynom zweiten Grades angenähert. Ein derartiges Polynom lässt sich allgemein beschreiben durch:

$$I(t) = at^2 + bt + c$$

$$(V6)$$

Unter Verwendung der Normierung ergibt sich:

$$I(t_{Nrm}) = at_{Nrm}^2 + bt_{Nrm} + c$$

$$(V7)$$

Für die Interpolation wird festgelegt, dass dieses Polynom durch die Punkte $P_1(-T_{PWM}|I(k-1))$; $P_2(0|I(k))$; $P_3(-T_{PWM}|I(k+1))$ verläuft.

Aufgrund der Normierung ergibt sich dementsprechend: $P_1(-1|I(k-1))$; $P_2(0|I(k))$; $P_3(1|I(k+1))$

Die Herleitung der Koeffizienten $a, b, c$ der Gleichung (V7) erfolgt durch die Polynominterpolation nach Lagrange.

$$\left. \begin{array}{l} a = \dfrac{I(k-1) - 2 \cdot I(k) + I(k+1)}{2} \\[2mm] b = \dfrac{I(k+1) - I(k-1)}{2} \\[2mm] c = I(k) \end{array} \right\} \Rightarrow I(t_{Nrm}) = \dfrac{I(k-1) - 2 \cdot I(k) + I(k+1)}{2} \cdot t_{Nrm}^2 + \dfrac{I(k+1) - I(k-1)}{2} \cdot t_{Nrm} + I(k)$$

$$(V8)$$

Der reale sinusförmige Stromverlauf wird dann im betrachteten Intervall als quadratische Funktion angenommen. Die interpolierte Funktion bietet eine recht genaue Approximation. Die Approximationsgenauigkeit nimmt mit steigender Frequenz ab.

Nun wird die Auswertung der PWM-Ansteuerungs-Pulsmuster zur Berechnung der in den Schaltkomponenten, also den Leistungshalbleitern, des Wechselrichters fließenden elektrischen Ladungen bzw. der entsprechenden Stromintegrale betrachtet.

Ziel dieses Abschnitts ist die Berechnung der linearen und quadratischen Stromintegrale der High-/Low-Side-Schaltkomponenten des Wechselrichters. Die quadratischen Stromintegrale sind die zuvor erwähnten quadratischen Integrale.

Allgemein gilt für die Berechnung der elektrischen Ladung der High-Side-Komponenten:

$$Q_{HS} = \int_{t_{Ein}}^{t_{Aus}} I(t) \cdot dt$$

$$(V9)$$

$$Q_{Sq,HS} = \int_{t_{Ein}}^{t_{Aus}} I(t)^2 \cdot dt$$

Die Normierung dieser Integrale nach (V5) ergibt:

$$Q_{HS} = T_{PWM} \cdot \int_{t_{Ein}}^{t_{Aus}} I(t_{Nrm}) \cdot dt_{Nrm}$$

$$(V10)$$

$$Q_{SqHS} = T_{PWM} \cdot \int_{t_{Ein}}^{t_{Aus}} I(t_{Nrm})^2 \cdot dt_{Nrm}$$

Es ergibt sich schließlich für die Berechnung der normierten elektrischen Ladung:

$$Q_{HS} = T_{PWM} \cdot \left( \int_{t_{Ein,Nrm}}^{t_{Aus,Nrm}} I(t_{Nrm}) \cdot dt_{Nrm} \right) = T_{PWM} \cdot \left( \int_{t_{Ein,Nrm}}^{t_{Aus,Nrm}} (a \cdot t_{Nrm}^2 + b \cdot t_{Nrm} + c) dt_{Nrm} \right) \quad (V11)$$

$$= T_{PWM} \cdot \left[ \frac{a}{3} \cdot \left( t_{Aus,Nrm}^3 - t_{Ein,Nrm}^3 \right) + \frac{b}{2} \cdot \left( t_{Aus,Nrm}^2 - t_{Ein,Nrm}^2 \right) + c \cdot \left( t_{Aus,Nrm} - t_{Ein,Nrm} \right) \right]$$

Das Quadrat der normierten elektrischen Ladung ergibt sich zu:

$$Q_{SqHS} = T_{PWM} \cdot \left( \int_{t_{Ein,Nrm}}^{t_{Aus,Nrm}} I(t_{Nrm})^2 \cdot dt_{Nrm} \right) = T_{PWM} \cdot \left( \int_{t_{Ein,Nrm}}^{t_{Aus,Nrm}} (a \cdot t_{Nrm}^2 + b \cdot t_{Nrm} + c)^2 \cdot dt_{Nrm} \right)$$

$$= \frac{T_{PWM}}{30} \left[ 6a^2(t_{Aus,Nrm}^5 - t_{Ein,Nrm}^5) + 15ab(t_{Aus,Nrm}^4 - t_{Ein,Nrm}^4) + 10b^2(t_{Aus,Nrm}^3 - t_{Ein,Nrm}^3) \right] +$$

$$c \cdot T_{PWM} \left[ \frac{2}{3} a(t_{Aus,Nrm}^3 - t_{Ein,Nrm}^3) + b(t_{Aus,Nrm}^2 - t_{Ein,Nrm}^2) \right] + c^2 \cdot T_{PWM} (t_{Aus,Nrm} - t_{Ein,Nrm})$$

(V12)

Für die Berechnung der elektrischen Ladung der Low-Side-Schaltkomponenten des Wechselrichters werden neben den High-Side-Integralen auch die kompletten Integrale benötigt. Die Gleichungen (V13) und V(14) beschreiben das komplette Integral und das zugehörige quadratische Integral.

$$Q_{Tot} = T_{PWM}' \cdot \int_0^1 I(t_{Nrm}) \cdot dt = T_{PWM}' \cdot \left( \int_0^1 (a \cdot t_{Nrm}^2 + b \cdot t_{Nrm} + c) dt_{Nrm} \right) = T_{PWM}' \cdot \left[ \frac{a}{3} + \frac{b}{2} + c \right] \tag{V13}$$

$$Q_{SqTot} = T_{PWM}' \cdot \left( \int_0^1 I(t_{Nrm})^2 \cdot dt_{Nrm} \right) = T_{PWM}' \cdot \left( \int_0^1 (a \cdot t_{Nrm}^2 + b \cdot t_{Nrm} + c)^2 \cdot dt_{Nrm} \right) \tag{V14}$$

$$= \frac{T_{PWM}'}{30} \left[ 6a^2 + 15ab + 10b^2 \right] + c \cdot T_{PWM}' \left[ \frac{2}{3} a + b \right] + c^2 \cdot T_{PWM}'$$

Daraus folgen für die Berechnung der Ladung der Low-Side-Schaltkomponenten die Gleichungen (V15) und (V16).

$$Q_{LS} = Q_{Tot} - Q_{HS} \tag{V15}$$

$$Q_{SqLS} = Q_{SqTot} - Q_{SqHS} \tag{V16}$$

Im Folgenden werden ausgehend von den unterschiedlichen möglichen auftretenden Pulsmustern bzw. Pulsmustertypen die zugehörigen Stromintegrale der High-Side- und Low-Side-Leistungshalbleiter einer Phase des betrachteten Systems berechnet.

Für eine Anwendung auf ein N-Phasiges System sollen, zur Berechnung der Stromintegrale der High-Side- und Low-Side-Leistungshalbleiter jeder Phase und der zugehörigen quadratischen Integrale, die zugehörigen Ein-/Ausschaltzeiten (die vorgegebenen Schaltzeiten) sowie der zugehörige Phasenstrom jeder Phase in den Gleichungen (V17*), (V18*), (V19*) und (V20*) eingesetzt werden.

Dabei wird die folgende Konvention zu den oben erwähnten Gleichungen festgelegt:

-  (V17*) → Elektrische Ladung bzw. das Stromintegral der High-Side-Leistungshalbleiter der Phase X des betrachteten Systems
-  (V18*) → Quadrat der elektrischen Ladung bzw. das quadratische Integral der High-Side-Leistungshalbleiter der Phase X des betrachteten Systems
-  (V19*) → Elektrische Ladung bzw. das Stromintegral des Low-Side-Leistungshalbleiter der Phase X des betrachteten Systems
-  (V20*) → Quadrat der elektrischen Ladung bzw. das quadratische Integral der Low-Side-Leistungshalbleiter der Phase X des betrachteten Systems

Das (*) verweist hierbei auf die getroffene Vereinfachung, dass die Leistungshalbleiter ideale Ein-/Ausschaltvorgänge aufweisen.

Wie zuvor erwähnt kann die Berechnungsvorschrift in Abhängigkeit von einem Typ eines Pulsansteuerverfahren, mit dem der Wechselrichter angesteuert wird, die Berechnung der fließenden elektrischen Ladungen nur für die High-Side-zugehörigen Schaltkomponenten - gemeint sind die Leistungshalbleiter - oder nur für die Low-Side-zugehörigen Schaltkomponenten durchführen. Hierbei sollte die Hälfte der Vollbrücke, also die High-Side oder Low-Side, für die Berechnung der Ladung verwendet werden, die es nicht erfordert, dass auch die Gesamtladung nach Gleichung (V13) berechnet wird. Zudem kann das Zeitintervall der jeweiligen Phase auf Grundlage der vorgegebenen Schaltzeiten dieser jeweiligen Phase vorteilhaft festgelegt werden, um die Berechnung der Integrale zu vereinfachen.

Es können folgende Pulsansteuerverfahren bzw. Typen zur Bestimmung von (V17*), (V18*), (V19*) und (V20*) unterschieden werden.

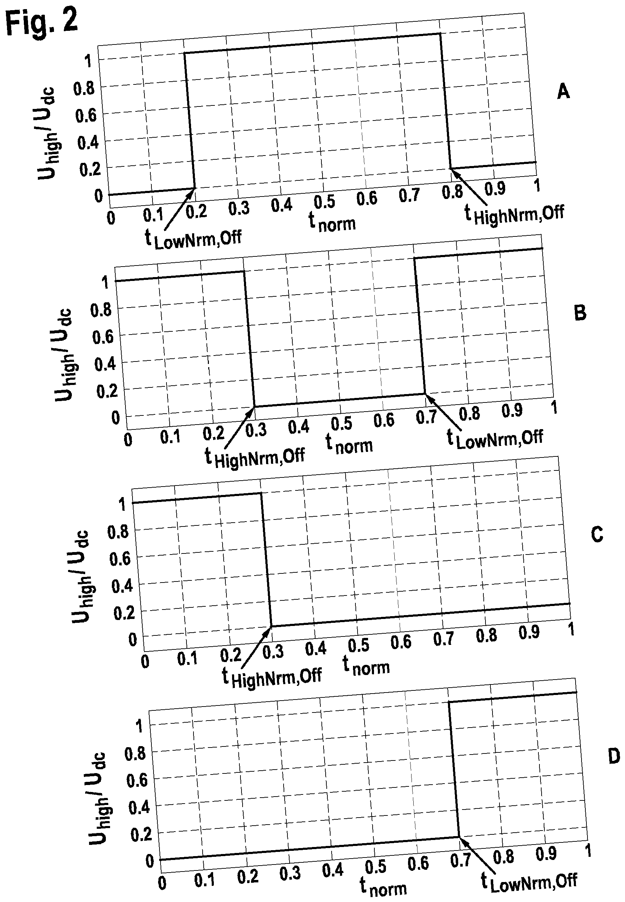

Das sogenannte Center-Aligned-PWM-Muster über eine Periodendauer ist im Abschnitt A von Fig. 2 dargestellt.

Für die High-Side ergeben sich:

$$Q_{HS} = T_{PWM} \cdot \int_{t_{LowNrm,off}}^{t_{HighNrm,off}} I(t_{Nrm}) \cdot dt_{Nrm} \tag{V17*}$$

$$Q_{SqHS} = T_{PWM} \cdot \int_{t_{LowNrm,off}}^{t_{HighNrm,off}} I^2(t_{Nrm}) \cdot dt_{Nrm} \tag{V18*}$$

Für die Low-Side ergeben sich :

$$Q_{LS} = Q_{Tot} - Q_{HS} \tag{V19*}$$

$$Q_{SqLS} = Q_{SqTot} - Q_{SqHS} \tag{V20*}$$

Das sogenannte Center-Aligned-invertiert-PWM-Muster über eine Periodendauer ist im Abschnitt B von Fig. 2 dargestellt.

Bei diesem Pulsmuster ist es geschickt, zunächst das Stromintegral für die Low-Side zu berechnen.

$$Q_{LS} = T_{PWM} \cdot \int_{t_{HighNrm,off}}^{t_{LowNrm,off}} I(t_{Nrm}) \cdot dt_{Nrm}$$

$$(\text{V19*})$$

$$Q_{SqLS} = T_{PWM} \cdot \int_{t_{HighNrm,off}}^{t_{LowNrm,off}} I^2(t_{Nrm}) \cdot dt_{Nrm} \tag{V20*}$$

Für die High-Side ergeben sich:

$$Q_{HS} = Q_{Tot} - Q_{LS} \tag{V17*}$$

$$Q_{SqHS} = Q_{SqTot} - Q_{SqLS} \tag{V18*}$$

Das sogenannte Left-Aligned-PWM-Muster über eine Periodendauer ist im Abschnitt C von Fig. 2 dargestellt.

Bei dem Left-Aligned-PWM-Muster ist die Einschaltzeit gleich Null $t_{LowNrm,Off} = 0$. Für die High-Side ergeben sich somit:

$$Q_{HS} = T_{PWM} \cdot \int_0^{t_{HighNrm,off}} I(t_{Nrm}) \cdot dt_{Nrm} \qquad \text{(V17*)}$$

$$Q_{SqHS} = T_{PWM} \cdot \int_0^{t_{HighNrm,off}} I^2(t_{Nrm}) \cdot dt_{Nrm} \qquad \text{(V18*)}$$

Für die Low-Side ergeben sich:

$$Q_{LS} = Q_{Tot} - Q_{HS} \qquad \text{(V19*)}$$

$$Q_{SqLS} = Q_{SqTot} - Q_{SqHS} \qquad \text{(V20*)}$$

Das sogenannte Right-Aligned-PWM-Muster über eine Periodendauer ist im Abschnitt D von Fig. 2 dargestellt.
Beim Right-Aligned-PWM-Muster ist die Ausschaltzeit gleich Null wegen $H_{ighNrm,Off}$ = 1. Für die High-Side ergeben sich somit:

$$Q_{HS} = T_{PWM} \cdot \int_{t_{LowNrm,off}}^1 I(t_{Nrm}) \cdot dt_{Nrm} \qquad \text{(V17*)}$$

$$Q_{SqHS} = T_{PWM} \cdot \int_{t_{LowNrm,off}}^1 I^2(t_{Nrm}) \cdot dt_{Nrm} \qquad \text{(V18*)}$$

Für die Low-Side ergeben sich:

$$Q_{LS} = Q_{Tot} - Q_{HS} \qquad \text{(V19*)}$$

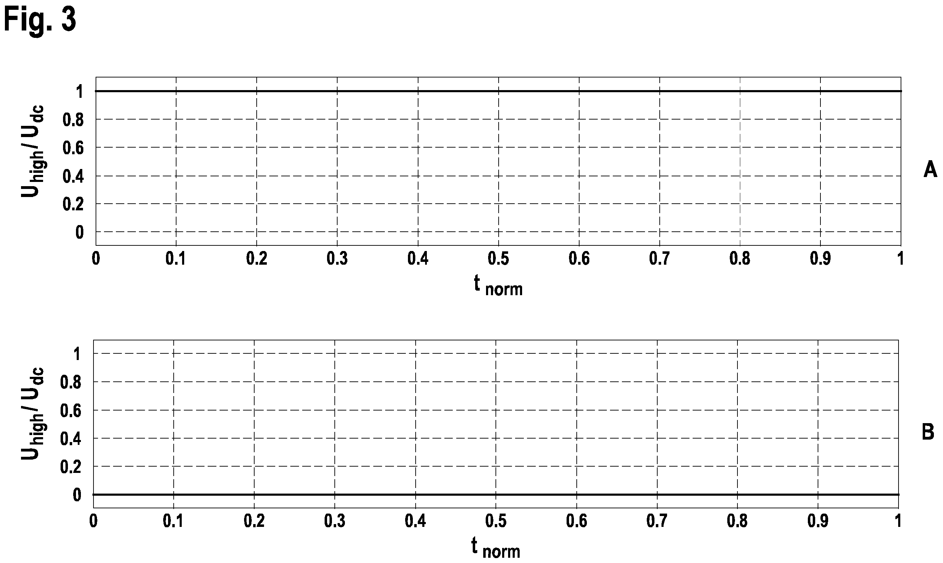

Das sogenannte Only-High-PWM-Muster über eine Periodendauer ist im Abschnitt A von Fig. 3 dargestellt. Bei diesem Pulsmuster wird nur das komplette Integral verwendet. Die Stromintegrale lauten somit:

$$Q_{HS} = Q_{Tot} \qquad \text{(V17*)}$$

$$Q_{SqHS} = Q_{SqTot} \qquad \text{(V18*)}$$

$$Q_{LS} = 0 \qquad \text{(V19*)}$$

$$Q_{SqLS} = 0 \qquad \text{(V20*)}$$

Das sogenannte Only-Low-PWM-Muster über eine Periodendauer ist im Abschnitt B von Fig. 3 dargestellt. Bei diesem Pulsmuster wird genauso wie beim Only-High-PWM nur das komplette Integral verwendet. Die Stromintegrale lauten somit:

$$Q_{HS} = 0 \qquad \text{(V17*)}$$

$$Q_{SqHS} = 0 \qquad\qquad\qquad (V18^*)$$

$$Q_{LS} = Q_{Tot} \qquad\qquad\qquad (V19^*)$$

$$Q_{SqLS} = Q_{SqTot} \qquad\qquad\qquad (V20^*)$$

Nachdem die ersten drei Terme der Gleichung (5), $Q_{SqHS\_U}$, $Q_{SqHS\_V}$, $Q_{SqHS\_W}$, also die quadratischen Integrale, in Abhängigkeit des Pulsmusters gemäß den obigen Darstellungen ermittelt werden können, soll nun die Berechnung der gemischten Integrale in Gleichung (5) dargestellt werden.

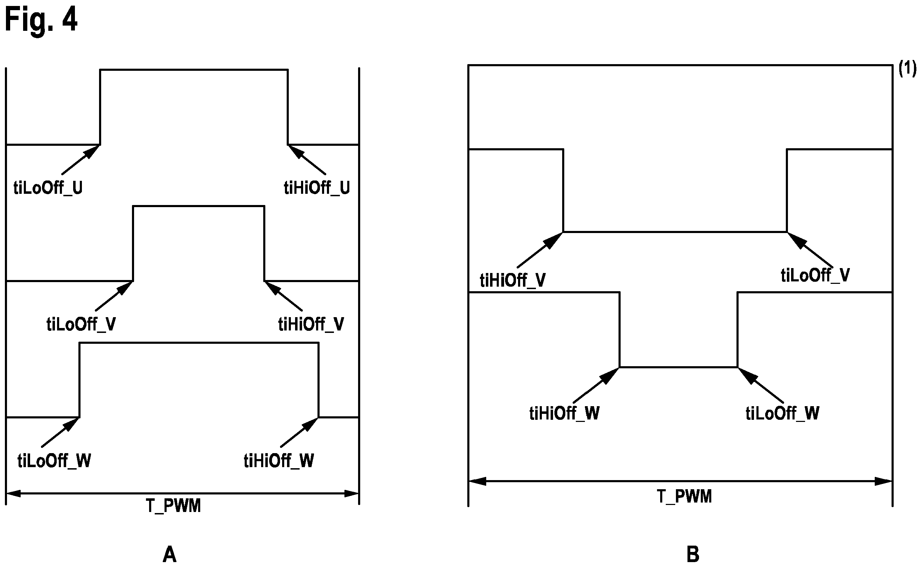

Hierbei ist es wichtig zu erwähnen, dass das Ergebnis der zwei gemischten Produkte, in denen der High-Side-Strom mit der kleinsten Leitend-Zeitdauer enthalten ist, gleich dem negativen Zweifachen des Quadrates des Stromintegrals, also des quadratischen Integrals, mit der kleinsten Leitend-Zeitdauer ist. Im Folgenden wird dies am Beispiel des im Abschnitt A von Fig. 4 veranschaulichten Center-Aligned-Pulsmusters erklärt.

Es werden zunächst die gemischten Integrale der Phase mit der kürzesten Leitend-Zeitdauer berechnet. Diese sind in der Gleichung (6) ausgeführt. Für die Berechnung des gemischten Integrals muss lediglich der Bereich betrachtet werden, in dem die zwei Phasen aktiv sind bzw. den Strom leiten. Außerdem ist in diesem Bereich das gemischte Integral Null. Da im vorliegenden beispielhaften Fall die Phase V die kleinste Leitend-Zeitdauer hat, sind zur Berechnung der beiden Integrale deren Ein-/Ausschaltzeit als Integralgrenzen einzusetzen. Aufgrund der gleichen Integralgrenzen für die beiden gemischten Integrale kann die Gleichung durch Ausklammern des Stroms mit der kleinsten Leitend-Zeitdauer vereinfacht werden.

$$2 \cdot \int_{tiLoOff\_V}^{tiHiOff\_V} Is_U(t) \cdot Is_V(t) \cdot dt + 2 \cdot \int_{tiLoOff\_V}^{tiHiOff\_V} Is_U(t) \cdot Is_W(t) \cdot dt =$$

$$2 \cdot \int_{tiLoOff\_V}^{tiHiOff\_V} Is_V(t) \cdot \left[ Is_U(t) + Is_W(t) \right] \cdot dt$$

$$(6)$$

Unter Annahme eines symmetrischen Antriebsystems gilt:

$$Is_U + Is_V + Is_W = 0 \Rightarrow Is_U + Is_W = -Is_V$$

Und somit folgt aus (6):

$$2 \cdot \int_{tiLoOff\_V}^{tiHiOff\_V} Is_U \cdot Is_V \, dt + 2 \cdot \int_{tiLoOff\_V}^{tiHiOff\_V} Is_U \cdot Is_W \, dt = -2 \cdot \underbrace{\int_{tiLoOff\_V}^{tiHiOff\_V} Is_V^2 \cdot dt}_{Q_{SqHS\_V}}$$

$$\Rightarrow 2 \cdot \int_{tiLoOff\_V}^{tiHiOff\_V} Is_U \cdot Is_V \, dt + 2 \cdot \int_{tiLoOff\_V}^{tiHiOff\_V} Is_U \cdot Is_W \, dt = -2 \cdot Q_{SqHS\_V}$$

$$(7)$$

Setzt man (7) in (5) ein, so erhält man:

$$\int_0^1 i_C^2 dt = Q_{SqHS\_U} - Q_{SqHS\_V} + Q_{SqHS\_W} + 2 \cdot \int_{tiLoOff\_U}^{tiHiOff\_U} Is_U \cdot Is_W \, dt - I_{Batt}^2 \qquad (8)$$

Somit ergibt sich für die Gleichung zur Berechnung des Effektivstroms $I_{C,rms}$ des Zwischenkreiskondensators:

$$I_{C,rms} = \sqrt{\frac{1}{T_{PWM}} \cdot \int_0^{T_{PWM}} i_C^2 \, dt}$$

$$= \frac{\sqrt{\underbrace{Q_{SqHS\_U} - Q_{SqHS\_V} + Q_{SqHS\_W} + 2 \cdot \int_{tiLoOff\_U}^{tiHiOff\_U} Is_U(t) \cdot Is_W(t) \cdot dt - I_{Batt}^2}_{Q_{ZWK,rms,Sq}}}}{T_{PWM}} \qquad (9)$$

Nun muss nur noch das gemischte Integral $2 \cdot \int_{tiLoOff\_U}^{tiHiOff\_U} Is_U(t) \cdot Is_W(t) \cdot dt$ berechnet werden.

Dies ist mit der Kenntnis des vorliegenden Pulsmusters berechenbar, was unten dargestellt wird.

Eine allgemeine Formel zur Berechnung des Effektivstroms $I_{C,rms}$ des Zwischenkreiskondensators ergibt sich somit zu:

$$I_{c,rms}^2 = \pm Q_{SqHS\_U} \pm Q_{SqHS\_V} \pm Q_{SqHS\_W} + 2 \cdot \int_{tiLoOff\_X}^{tiHiOff\_X} Is_{HS\_X} \cdot Is_{HS\_Y} \, dt - I_{Batt}^2$$

$$(10)$$

Bezüglich dieser allgemeinen Formel (10) gelten die folgenden Regeln:

• Das quadratische Integral der Phase mit der kleinsten Leitend-Zeitdauer trägt das negative Vorzeichen.

• Die quadratischen Integrale der Phasen mit der zweitkleinsten Leitend-Zeitdauer und der größten Leitend-Zeitdauer tragen das positive Vorzeichen.

• Die Integralgrenzen des zu berechnenden gemischten Integrals beziehen sich auf die Ein-/Ausschaltzeiten, also die vorgegeben Schaltzeiten, der Phase mit der zweitkleinsten Leitend-Zeitdauer.

• $IS_{HS\_X}$ bezeichnet den Phasenstrom mit der zweitkleinsten Leitend-Zeitdauer.

• $IS_{HS\_Y}$ bezeichnet den Phasenstrom mit der größten Leitend-Zeitdauer.

Dabei werden folgende Fälle unterschieden:

1. Fall: $dyc_U < dyc_V < dyc_W$

$$I_{c,rms}^2 = -Q_{SqHS\_U} + Q_{SqHS\_V} + Q_{SqHS\_W} + 2 \cdot \int_{tiLoOff\_V}^{tiHiOff\_V} Is_{HS\_W} \cdot Is_{HS\_V} \, dt - I_{Batt}^2 \qquad (10\text{-}1)$$

2. Fall: $dyc_U < dyc_W < dyc_V$

$$I_{c,rms}^2 = -Q_{SqHS\_U} + Q_{SqHS\_V} + Q_{SqHS\_W} + 2 \cdot \int_{tiLoOff\_W}^{tiHiOff\_W} Is_{HS\_W} \cdot Is_{HS\_V} \, dt - I_{Batt}^2 \tag{11}$$

3. Fall: $dyc_V < dyc_W < dyc_U$

$$I_{c,rms}^2 = Q_{SqHS\_U} - Q_{SqHS\_V} + Q_{SqHS\_W} + 2 \cdot \int_{tiLoOff\_W}^{tiHiOff\_W} Is_{HS\_W} \cdot Is_{HS\_U} \, dt - I_{Batt}^2 \tag{12}$$

4. Fall: $dyc_V < dyc_U < dyc_W$

$$I_{c,rms}^2 = Q_{SqHS\_U} - Q_{SqHS\_V} + Q_{SqHS\_W} + 2 \cdot \int_{tiLoOff\_U}^{tiHiOff\_U} Is_{HS\_W} \cdot Is_{HS\_U} \, dt - I_{Batt}^2 \tag{13}$$

5. Fall: $dyc_W < dyc_V < dyc_U$

$$I_{c,rms}^2 = Q_{SqHS\_U} + Q_{SqHS\_V} - Q_{SqHS\_W} + 2 \cdot \int_{tiLoOff\_V}^{tiHiOff\_V} Is_{HS\_U} \cdot Is_{HS\_V} \, dt - I_{Batt}^2 \tag{14}$$

6. Fall: $dyc_W < dyc_U < dyc_V$

$$I_{c,rms}^2 = Q_{SqHS\_U} + Q_{SqHS\_V} - Q_{SqHS\_W} + 2 \cdot \int_{tiLoOff\_U}^{tiHiOff\_U} Is_{HS\_U} \cdot Is_{HS\_V} \, dt - I_{Batt}^2 \tag{15}$$

Gemäß den obigen Formeln (10) bis (15) wird der Effektivstrom $I_{C,rms}$ des Zwischenkreiskondensators für beliebige Pulsmuster zur Ansteuerung des Wechselrichters nur für die bzw. auf Grundlage der High-Side-Schaltkomponenten bzw. die darin fließenden elektrischen Ladungen berechnet.

Ein Sonderfall ergibt sich bei dem Flat-Top-Pulsmuster, das im Abschnitt B von Fig. 4 veranschaulicht ist. Bei dem Flat-Top-Pulsmuster ist es vorteilhaft, die Berechnung auf die Low-Side-Schaltkomponenten umzustellen, da dadurch die Berechnung des Effektivstroms vereinfacht werden kann.

Betrachtet man Knoten K2 in Fig. 1, so ergibt sich:

$$\begin{aligned} (K2) :&\Rightarrow i_{Batt} = i_C + Is_{LS\_U} + Is_{LS\_V} + Is_{LS\_W} \\ &\Rightarrow i_{Batt} - i_C = Is_{LS\_U} + Is_{LS\_V} + Is_{LS\_W} \end{aligned} \tag{16}$$

Analog zur Gleichung (10) folgt daraus:

$$I_{c,rms}^2 = \pm Q_{SqLS\_U} \pm Q_{SqLS\_V} \pm Q_{SqLS\_W} + 2 \cdot \int_{tiLoOff\_X}^{tiHiOff\_X} Is_{LS\_X} \cdot Is_{LS\_Y} \, dt - I_{Batt}^2 \tag{17}$$

Somit können folgende Fälle abgeleitet werden:

1. Fall: $dyc_U < dyc_V < dyc_W$

$$I_{c,rms}^2 = -Q_{SqLS\_U} + Q_{SqLS\_V} + Q_{SqLS\_W} + 2 \cdot \int_{tiLoOff\_V}^{tiHiOff\_V} Is_{LS\_W} \cdot Is_{LS\_V} \, dt - I_{Batt}^2 \tag{18}$$

2. Fall: $dyc_U < dyc_W < dyc_V$

$$I_{c,rms}^2 = -Q_{SqLS\_U} + Q_{SqLS\_V} + Q_{SqLS\_W} + 2 \cdot \int_{tiLoOff\_W}^{tiHiOff\_W} Is_{LS\_W} \cdot Is_{LS\_V} dt - I_{Batt}^2 \qquad (19)$$

3. Fall: $dyc_V < dyc_W < dyc_U$

$$I_{c,rms}^2 = Q_{SqLS\_U} - Q_{SqLS\_V} + Q_{SqLS\_W} + 2 \cdot \int_{tiLoOff\_W}^{tiHiOff\_W} Is_{LS\_W} \cdot Is_{LS\_U} dt - I_{Batt}^2 \qquad (20)$$

4. Fall: $dyc_V < dyc_U < dyc_W$

$$I_{c,rms}^2 = Q_{SqLS\_U} - Q_{SqLS\_V} + Q_{SqLS\_W} + 2 \cdot \int_{tiLoOff\_U}^{tiHiOff\_U} Is_{LS\_W} \cdot Is_{LS\_U} dt - I_{Batt}^2 \qquad (21)$$

5. Fall: $dyc_W < dyc_V < dyc_U$

$$I_{c,rms}^2 = Q_{SqLS\_U} + Q_{SqLS\_V} - Q_{SqLS\_W} + 2 \cdot \int_{tiLoOff\_V}^{tiHiOff\_V} Is_{LS\_U} \cdot Is_{LS\_V} dt - I_{Batt}^2 \qquad (22)$$

6. Fall: $dyc_W < dyc_U < dyc_V$

$$I_{c,rms}^2 = Q_{SqLS\_U} + Q_{SqLS\_V} - Q_{SqLS\_W} + 2 \cdot \int_{tiLoOff\_U}^{tiHiOff\_U} Is_{LS\_U} \cdot Is_{LS\_V} dt - I_{Batt}^2 \qquad (23)$$

Gemäß den obigen Formeln (17) bis (23) wird der Effektivstrom $I_{C,rms}$ des Zwischenkreiskondensators für das Flat-Top-Pulsmuster zur Ansteuerung des Wechselrichters nur für die bzw. auf Grundlage der Low-Side-Schaltkomponenten bzw. die darin fließenden elektrischen Ladungen berechnet.

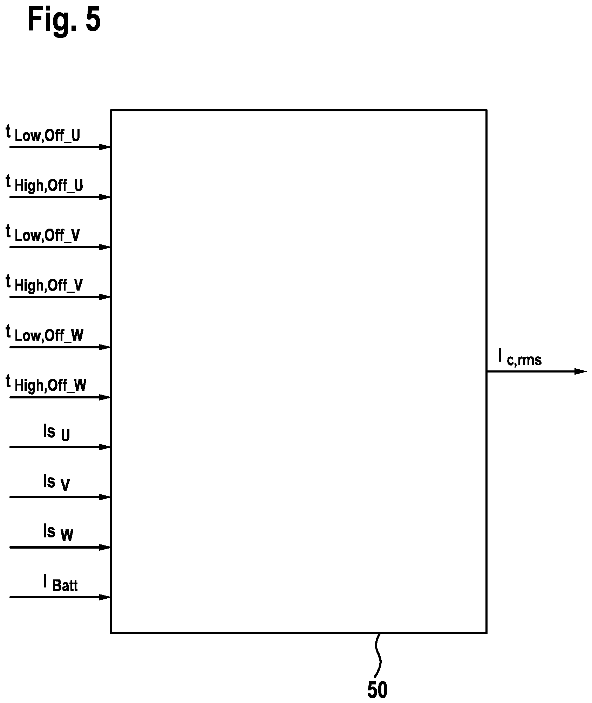

Fig. 5 veranschaulicht eine Vorrichtung 50 zum Schätzen des Effektivstroms des Zwischenkreiskondensators für eine dreiphasig bestromte elektrische Maschine. Wie in Fig. 5 gezeigt, ist die Vorrichtung 50 ausgebildet, als Eingangsgrößen sechs Schaltzeitgrößen, nämlich jeweils zwei Schaltzeiten pro Phase, drei gemessene Phasenströme der drei Phasen der elektrischen Maschine und den Batteriegleichstrom zu empfangen und die Eingangsgrößen zur Berechnung des Effektivstroms des Zwischenkreiskondensators gemäß der oben erläuterten Berechnungsvorschrift zu verwenden. Für ein symmetrisches System kann einer der Phasenstromeingänge entfallen, da aus den gemessenen Phasenströmen von zwei Phasen in der Vorrichtung 50 der Phasenstrom der dritten Phase berechnet werden kann.

**Patentansprüche**

1. Verfahren zum Schätzen eines Effektivstroms ($I_{C,rms}$) eines Zwischenkreiskondensators ($C_{ZWK}$) für ein Gesamtsystem einer Batterie (1), eines Wechselrichters (9) und einer N-phasigen elektrischen Maschine (6), bevorzugt einer Synchronmaschine, wobei in dem Gesamtsystem der Wechselrichter (9) eine von der Batterie (1) empfangene Gleichstromleistung zur Bestromung der elektrischen Maschine mit N Phasenströmen umrichtet, und wobei der zu schätzende Effektivstrom ($I_{C,rms}$) des Zwischenkreiskondensators gemäß einer Berechnungsvorschrift berechnet wird, der vorgegebene Schaltzeiten ($t_{Low,Off}$, $t_{High,Off}$) der N Phasen der elektrischen Maschine, gemessene Phasenströme ($IS_U$, $IS_V$, $IS_W$) von N-1 Phasen oder N Phasen der elektrischen Maschine und ein vorgegebener Batteriegleichstrom ($I_{Batt}$) als Eingangsgrößen zugeführt werden, **dadurch gekennzeichnet, dass** die Berechnungsvorschrift die vorgegebenen Schaltzeiten ($t_{Low,Off}$, $t_{High,Off}$) zur Festlegung von Intervallgrenzen durch die Berechnungsvorschrift zu berechnender Zeitintegrale verwendet, wobei die vorgegebenen Schaltzeiten als die Intervallgrenzen verwendet werden, und wobei die Berechnungsvorschrift für eine jeweilige Phase, als ein quadratisches Integral, ein Zeitintegral eines quadrierten zugeführten Phasenstroms und/oder für zwei Phasen, als ein gemischtes Integral, ein Zeitintegral eines Produkts der diesen Phasen zugeordneten und zugeführten Phasenströme annähert mittels Approximation des jeweiligen zugeführten Phasenstroms durch ein Polynom zweiten Grades.

2. Verfahren nach Anspruch 1, **dadurch gekennzeichnet, dass** die Berechnungsvorschrift, als jeweilige quadratische Integrale, quadrierte Stromintegrale ($Q_{SqHS\_U}$, $Q_{SqHS\_V}$, $Q_{SqHS\_W}$ ; $Q_{SqLS\_U}$, $Q_{SqLS\_V}$, $Q_{SqLS\_W}$) auf Grundlage der zugeführten Eingangsgrößen berechnet.

3. Verfahren nach Anspruch 1 oder 2, **dadurch gekennzeichnet, dass** auf Grundlage der gemessenen Phasenströme der N-1 Phasen ein Phasenstrom einer von den N-1 Phasen unterschiedlichen, N-ten Phase berechnet und der Berechnungsvorschrift als Phasenstrom der N-ten Phase zugeführt wird.

4. Verfahren nach einem der vorhergehenden Ansprüche, **dadurch gekennzeichnet, dass** die Berechungsvorschrift für mindestens eine Phase, bevorzugt alle, der N Phasen, als ein quadratisches Integral, ein Zeitintegral eines Quadrats eines der Phase zugeordneten und als Eingangsgröße zugeführten Phasenstroms auf Grundlage der der Phase zugeordneten und als Eingangsgröße zugeführten Schaltzeiten ($t_{Low,Off}$, $t_{High,Off}$) berechnet.

5. Verfahren nach einem der vorhergehenden Ansprüche, **dadurch gekennzeichnet, dass** die Berechnungsvorschrift für zwei Phasen der N Phasen, als ein gemischtes Integral, ein Zeitintegral eines Produkts der diesen Phasen zugeordneten und als Eingangsgrößen zugeführten Phasenströme auf Grundlage der den Phasen zugeordneten und als Eingangsgrößen zugeführten Schaltzeiten ($t_{Low,Off}$, $t_{High,Off}$) berechnet.

6. Verfahren nach Anspruch 5, **dadurch gekennzeichnet, dass** die Berechnungsvorschrift für genau zwei Phasen der N=3 Phasen, als ein gemischtes Integral, das Zeitintegral des Produkts der diesen Phasen zugeordneten und als Eingangsgrößen zugeführten Phasenströme auf Grundlage von genau einer Phase der zwei Phasen zugeordneten und als Eingangsgröße zugeführten Schaltzeiten ($t_{Low,Off}$, $t_{High,Off}$) berechnet, wobei ferner bevorzugt die genau zwei Phasen eine Phase mit einer zweitkleinsten Leitend-Zeitdauer und eine Phase mit einer größten Leitend-Zeitdauer sind, und wobei ferner bevorzugt die Berechnung nur auf Grundlage der der Phase mit der zweitkleinsten Leitend-Zeitdauer zugeordneten Schaltzeiten durchgeführt wird.

7. Verfahren einem der vorhergehenden Ansprüche, **dadurch gekennzeichnet, dass** die quadratischen Integrale und die gemischten Integrale für beliebige, insbesondere von einem Flat-Top-Pulsmuster unterschiedliche, Pulsmuster zur Ansteuerung des Wechselrichters nur für High-Side-Schaltkomponenten des Wechselrichters berechnet werden, und/oder für Flat-Top-Pulsmuster zur Ansteuerung des Wechselrichters die quadratischen Integrale und die gemischten Integrale nur für Low-Side-Schaltkomponenten des Wechselrichters berechnet werden, und/oder der Effektivstrom ($I_{C,rms}$) des Zwischenkreiskondensators als eine Summe der berechneten quadratischen und gemischten Integrale abzüglich des vorgegebenen Batteriegleichstroms ($I_{Batt}$) berechnet und geschätzt wird, wobei das quadratische Integral der Phase mit der kleinsten Leitend-Zeitdauer negativ in die Summe eingeht.

8. Vorrichtung zum Schätzen eines Effektivstroms ($I_{C,rms}$) eines Zwischenkreiskondensators ($C_{ZWK}$) für ein Gesamtsystem einer Batterie (1), eines Wechselrichters (9) und einer N-phasigen elektrischen Maschine (6), bevorzugt einer Synchronmaschine, wobei in dem Gesamtsystem der Wechselrichter (9) dafür vorgesehen ist, eine von der Batterie (1) empfangene Gleichstromleistung zur Bestromung der elektrischen Maschine mit N Phasenströmen umzurichten, und wobei die Vorrichtung ausgebildet ist zum Berechnen des zu schätzenden Effektivstroms ($I_{C,rms}$) des Zwischenkreiskondensators gemäß einer Berechnungsvorschrift, der vorgegebene Schaltzeiten ($t_{Low,Off}$, $t_{High,Off}$) der N Phasen der elektrischen Maschine, gemessene Phasenströme ($IS_u$, $IS_v$, $IS_w$) von N-1 Phasen oder N Phasen der elektrischen Maschine und ein vorgegebener Batteriegleichstrom ($I_{Batt}$) als Eingangsgrößen zugeführt werden, wobei die Vorrichtung darüber hinaus zum Ausführen mindestens eines Verfahrens nach einem der Ansprüche 1 bis 7 ausgebildet ist.

**Claims**

1. Method for estimating an RMS current ($I_{C,rms}$) of an intermediate-circuit capacitor ($C_{ZWK}$) for an overall system made up of a battery (1), an inverter (9), and an N-phase electric machine (6), preferably a synchronous machine, wherein, in the overall system, the inverter (9) converts direct-current power received by the battery (1) for supplying the electric machine with N phase currents, and wherein the RMS current ($I_{C,rms}$) to be estimated of the intermediate-circuit capacitor is calculated according to a calculation specification, to which predefined switching times ($t_{Low,Off}$, $t_{High,Off}$) of the N phases of the electric machine, measured phase currents (ISu, ISv, ISw) of N-1 phases or N phases of the electric machine, and a predefined battery direct current ($I_{Batt}$) are supplied as input variables, **characterized in that** the calculation specification uses the predefined switching times ($t_{Low,Off}$, $t_{High,Off}$) for the determination of interval limits via the calculation specification for time integrals to be calculated, wherein the predefined switching times are used as the interval limits, and wherein, for a respective phase, the calculation specification approximates a time integral of a squared supplied phase current, as a quadratic integral, and/or for two phases, the calculation specification approximates a time integral of a product of the phase currents associated with and supplied to these phases, as a mixed integral, by means of approximation of the respective supplied phase current via a second-order polynomial.

2. Method according to Claim 1, **characterized in that** the calculation specification calculates squared current integrals ($Q_{SqHS\_U}$, $Q_{SqHS\_V}$, $Q_{SqHS\_W}$; $Q_{SqLS\_U}$, $Q_{SqLS\_V}$, $Q_{SqLS\_W}$) as respective quadratic integrals, based on the supplied input variables.

3. Method according to Claim 1 or 2, **characterized in that** a phase current of an Nth phase which is different from the N-1 phases is calculated based on the measured phase currents of the N-1 phases, and is supplied to the calculation specification as phase current of the Nth phase.

4. Method according to one of the preceding claims, **characterized in that**, for at least one phase, preferably all, of the N phases, the calculation specification calculates a time integral of a square of a phase current associated with the phase and supplied as an input variable, as a quadratic integral, based on the switching times ($t_{Low,Off}$, $t_{High,Off}$) associated with the phase and supplied as an input variable.

5. Method according to one of the preceding claims, **characterized in that**, for two phases of the N phases, the calculation specification calculates a time integral of a product of the phase currents associated with these phases and supplied as input variables, as a mixed integral, based on the switching times ($t_{Low,Off}$, $t_{High,Off}$) associated with the phases and supplied as input variables.

6. Method according to Claim 5, **characterized in that**, for exactly two phases of the N=3 phases, the calculation specification calculates the time integral of the product of the phase currents associated with these phases and supplied as input variables, as a mixed integral, based on switching times ($t_{Low,Off}$, $t_{High,Off}$) associated with exactly one phase of the two phases and supplied as an input variable, wherein furthermore the exactly two phases are preferably a phase having a second-smallest conductive period and a phase having a greatest conductive period, and wherein furthermore the calculation is preferably carried out based only on the switching times associated with the phase having the second-smallest conductive period.

7. Method according to one of the preceding claims, **characterized in that** the quadratic integrals and the mixed integrals are calculated for any arbitrary pulse patterns, in particular differing from a flat-top pulse pattern, for driving the inverter, only for high-side switching components of the inverter, and/or for flat-top pulse patterns for driving the inverter, the quadratic integrals and the mixed integrals are calculated only for low-side switching components of the inverter, and/or the RMS current ($I_{C,rms}$) of the intermediate-circuit capacitor is calculated and estimated as a sum of the calculated quadratic and mixed integrals, minus the predefined battery direct current ($I_{Batt}$), wherein the quadratic integral of the phase having the smallest conductive period enters the sum negatively.

8. Apparatus for estimating an RMS current ($I_{c,rms}$) of an intermediate-circuit capacitor ($C_{ZWK}$) for an overall system made up of a battery (1), an inverter (9), and an N-phase electric machine (6), preferably a synchronous machine, wherein, in the overall system, the inverter (9) is provided to convert direct-current power received by the battery (1) for supplying the electric machine with N phase currents, and wherein the apparatus is designed to calculate the RMS current ($I_{C,rms}$) to be estimated of the intermediate-circuit capacitor according to a calculation specification, to which predefined switching times ($t_{Low,Off}$, $t_{High,Off}$) of the N phases of the electric machine, measured phase currents ($IS_u$, $IS_v$, $IS_w$) of N-1 phases or N phases of the electric machine, and a predefined battery direct current ($I_{Batt}$) are supplied as input variables, wherein, in addition, the apparatus is designed to carry out at least one method according to one of Claims 1 to 7.

**Revendications**

1. Procédé permettant d'estimer un courant efficace ($I_{C,rms}$) d'un condensateur de circuit intermédiaire ($C_{ZWK}$) pour un système complet d'une batterie (1), d'un onduleur (9) et d'une machine électrique à N phases (6), de préférence d'une machine synchrone, dans lequel, dans le système complet, l'onduleur (9) convertit une puissance en courant continu reçue de la batterie (1) pour alimenter la machine électrique avec N courants de phase, et le courant efficace ($I_{C,rms}$) à estimer du condensateur de circuit intermédiaire étant calculé selon une règle de calcul prescrite dans laquelle des temps de commutation prédéfinis ($t_{Low,Off}$, $t_{High,Off}$) des N phases de la machine électrique, des courants de phase mesurés (ISu, ISv, ISw) de N-1 phases ou N phases de la machine électrique et un courant continu de batterie prédéfini ($I_{Batt}$) sont entrés en tant que grandeurs d'entrée,

**caractérisé en ce que** la règle de calcul prescrite utilise les temps de commutation prédéfinis ($t_{Low,Off}$, $t_{High,Off}$) pour fixer des limites d'intervalle d'intégrales de temps à calculer par la règle de calcul prescrite, les temps de commutation prédéfinis étant utilisés en tant que limites d'intervalle, et dans lequel la règle de calcul prescrite calcule par approximation, pour une phase respective, en tant qu'intégrale quadratique une intégrale de temps d'un courant de phase amené au carré, et/ou pour deux phases, en tant qu'intégrale mixte une intégrale de temps d'un produit des courants de phase associés et amenés à ces phases au moyen d'une approximation du courant de phase amené respectif par un polynôme du second degré.

2. Procédé selon la revendication 1, **caractérisé en ce que** la règle de calcul prescrite calcule en tant qu'intégrales quadratiques respectives des intégrales de courant au carré ($Q_{SqHS\_U}$, $Q_{SqHS\_V}$, $Q_{SqHS\_W}$; $Q_{SqLS\_U}$, $Q_{SqLS\_V}$, $Q_{SqLS\_W}$) sur la base des grandeurs d'entrée entrées.

3. Procédé selon la revendication 1 ou 2, **caractérisé en ce que** sur la base des courants de phase mesurés des N-1 phases, un courant de phase d'une N-ième phase, différente des N-1 phases, est calculé et est entré dans la règle de calcul prescrite en tant que courant de phase de la N-ième phase.

4. Procédé selon l'une quelconque des revendications précédentes, **caractérisé en ce que** la règle de calcul prescrite calcule pour au moins une phase, de préférence pour l'ensemble, des N phases en tant qu'intégrale quadratique une intégrale de temps d'un carré d'un courant de phase associé à la phase et entré en tant que grandeur d'entrée, sur la base des temps de commutation ($t_{Low,Off}$, $t_{High,Off}$) associés à la phase et entrés en tant que grandeur d'entrée.

5. Procédé selon l'une quelconque des revendications précédentes, **caractérisé en ce que** la règle de calcul prescrite calcule pour deux phases des N phases en tant qu'intégrale mixte une intégrale de temps d'un produit des courants de phase associés à ces phases et entrés en tant que grandeurs d'entrée sur la base des temps de commutation ($t_{Low,Off}$, $t_{High,Off}$) associés aux phases et entrés en tant que grandeurs d'entrée.

6. Procédé selon la revendication 5, **caractérisé en ce que** la règle de calcul prescrite calcule pour exactement deux phases des N = 3 phases, en tant qu'intégrale mixte, l'intégrale de temps du produit des courants de phase associés à ces phases et entrés en tant que grandeurs d'entrée, sur la base d'exactement une phase des temps de commutation ($t_{Low,Off}$, $t_{High,Off}$) associés à deux phases et entrés en tant que grandeur d'entrée, dans lequel en outre, de préférence les exactement deux phases sont une phase ayant une durée de conduction la deuxième plus petite et une phase ayant une durée de conduction la plus grande, et dans lequel en outre, le calcul est de préférence effectué uniquement sur la base des temps de commutation associés à la phase ayant la durée de conduction la deuxième plus petite.

7. Procédé selon l'une quelconque des revendications précédentes, **caractérisé en ce que** les intégrales quadratiques et les intégrales mixtes sont calculées pour des modèles d'impulsion quelconques, en particulier différentes d'un modèle d'impulsion à plateau, pour le pilotage de l'onduleur uniquement pour des composants de commutation côté haut de l'onduleur, et/ou pour des modèles d'impulsion à plateau, pour le pilotage de l'onduleur, les intégrales quadratiques et les intégrales mixtes ne sont calculées que pour des composants de commutation côté bas de l'onduleur, et/ou le courant efficace ($I_{C,rms}$) du condensateur de circuit intermédiaire est calculé et estimé en tant que somme des intégrales quadratiques et mixtes calculées moins le courant continu de batterie prédéfini ($I_{Batt}$), l'intégrale quadratique de la phase ayant la durée de conduction la plus courte intervenant négativement dans la somme.

8. Dispositif permettant d'estimer un courant efficace ($I_{C,rms}$) d'un condensateur de circuit intermédiaire ($C_{ZWK}$) pour un système complet d'une batterie (1), d'un onduleur (9) et d'une machine électrique à N phases (6), de préférence d'une machine synchrone, dans le système complet, l'onduleur (9) étant prévu pour convertir une puissance en courant continu reçue de la batterie (1) pour alimenter la machine électrique avec N courants de phase, et le dispositif étant réalisé pour calculer le courant efficace ($I_{C,rms}$) à estimer du condensateur de circuit intermédiaire selon une règle de calcul prescrite dans laquelle des temps de commutation prédéfinis ($t_{Low,Off}$, $t_{High,Off}$) des N phases de la machine électrique, des courants de phase mesurés ($IS_U$, $IS_V$, $IS_W$) de N-1 phases ou N phases de la machine électrique et un courant continu de batterie prédéfini ($I_{Batt}$) sont entrés en tant que grandeurs d'entrée, le dispositif étant en outre réalisé pour effectuer au moins un procédé selon l'une quelconque des revendications 1 à 7.

**Fig. 1**

# Fig. 2

Fig. 3

## Fig. 4

tiLoOff_U          tiHiOff_U

tiLoOff_V          tiHiOff_V

tiLoOff_W          tiHiOff_W

T_PWM

A

tiHiOff_V          tiLoOff_V

tiHiOff_W          tiLoOff_W

T_PWM

B

(1)

EP 3 278 448 B1

# Fig. 5

$t_{Low,Off\_U}$ →

$t_{High,Off\_U}$ →

$t_{Low,Off\_V}$ →

$t_{High,Off\_V}$ →

$t_{Low,Off\_W}$ →

$t_{High,Off\_W}$ →

$Is_U$ →

$Is_V$ →

$Is_W$ →

$I_{Batt}$ →

$I_{c,rms}$ →

**50**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1988402 A1

- DE 102012215811 A1

**In der Beschreibung aufgeführte Nicht-Patentliteratur**

- Analytical calculation of the RMS current stress on the DC-link capacitor of voltage-PWM converter systems. *IEE PROCEEDINGS: ELECTRIC POWER APPLICATIONS, INSTITUTION OF ELECTRICAL ENIGNEERS,* 01. Juli 2006, vol. 153 (4), 535-543